# FASCICULE DE BREVET EUROPEEN

(11) **EP 1 488 443 B1**
(45) Date de publication et mention de la délivrance du brevet: **16.08.2006**
(21) Numéro de dépôt: 03720650.5
(22) Date de dépôt: 27.02.2003
(51) Int. Cl.: H01J 37/32

(54) **DISPOSITIF DE CONFINEMENT D'UN PLASMA DANS UN VOLUME**
VORRICHTUNG ZUR BEGRENZUNG EINES PLASMAS IN EINEM VOLUMEN
DEVICE FOR CONFINEMENT OF A PLASMA WITHIN A VOLUME

(30) Priorité: 28.03.2002 FR 0203900
(43) Date de publication de la demande: 22.12.2004
(73) Titulaire: CENTRE NATIONAL DE LA RECHERCHE SCIENTIFIQUE (CNRS), 75016 Paris (FR)
(72) Inventeur: LACOSTE, Ana, F-38950 St Martin le Vinoux (FR); ARNAL, Yves, Alban-Marie, F-38320 Poisat (FR); BECHU, Stéphane, F-01200 Bellegarde sur Valserine (FR); PELLETIER, Jacques, F-38400 Saint-Martin-d'Hères (FR)
(74) Mandataire: Texier, Christian
(86) Numéro de dépôt international: PCT/FR2003/000634
(87) Numéro de publication internationale: WO 2003/083893

(56) Documents cités:
- EP-A- 0 300 447
- WO-A-01/73812
- US-A- 4 745 337
- LIMPAECHER R ET AL: "MAGNETIC MULTIPOLE CONTAINMENT OF LARGE UNIFORM COLLISIONLESS QUIESCENT PLASMAS" REVIEW OF SCIENTIFIC INSTRUMENTS, AMERICAN INSTITUTE OF PHYSICS. NEW YORK, US, vol. 44, no. 6, 1 juin 1973 (1973-06-01), pages 726-731, XP000560655 ISSN: 0034-6748 cité dans la demande

## Description

### DOMAINE TECHNIQUE GENERAL.

La présente invention concerne le domaine technique général des plasmas, depuis les plus basses pressions (10⁻⁶ torr ou moins) jusqu'aux pressions de l'ordre de 10⁻² torr.

Plus précisément, l'invention concerne le confinement complet ou partiel d'un plasma dans un volume, et notamment le confinement dans de grands volumes de plasmas uniformes à basses et très basses pressions.

Elles trouvent notamment avantageusement application dans toutes les techniques qui nécessitent d'une part la production d'un plasma dense et uniforme, et d'autre part le confinement de ce plasma uniforme dans une enceinte par exemple dans laquelle se déroule l'application.

On rappelle qu'un plasma est un milieu gazeux, conducteur, constitué d'électrons, d'ions et de particules neutres, macroscopiquement neutre électriquement. Un plasma est obtenu à l'aide d'un champ électrique, par ionisation d'un gaz par les électrons accélérés dans ce champ électrique.

On peut pour certaines applications souhaiter confiner un plasma dans le volume d'une enceinte.

Le confinement des plasmas dans un volume peut être effectué par des aimants permanents.

Dans ce cas, le confinement est généralement réalisé en plaçant à la périphérie du volume de confinement - à l'intérieur ou à l'extérieur des parois de l'enceinte - des aimants permanents présentant au plasma des polarités nord et sud alternées. La périphérie de l'enceinte est donc soumise à un champ magnétique. On appelle cette technique le « confinement magnétique multipolaire ».

Le principe de confinement multipolaire des particules « espèces chargées » formant le plasma est le suivant.

Les particules chargées du plasma se déplacent dans l'enceinte entre des régions périphériques soumises au champ magnétique formé par les aimants permanents et des régions centrales non soumises audit champ.

Les particules chargées rentrant dans la région d'influence d'un champ magnétique multipolaire sont soumises à trois principaux mécanismes.
1/ mécanisme 1. Les particules chargées issues d'une région exempte de champ magnétique peuvent être réfléchies sur et par le champ magnétique et retournent dans la région non soumise au champ magnétique ;
2/ mécanisme 2. Les particules chargées issues d'une région exempte de champ magnétique franchissent en totalité la région de champ magnétique, lorsque leur trajectoire est presque parallèle aux lignes de champ magnétique.
   Les particules chargées qui sont soumises au mécanisme 2 sont perdues pour le plasma. Ces particules arrivent d'une région exempte de champ magnétique pour aller vers des régions de convergence des lignes de champ magnétique, c'est-à-dire, soit directement sur les pôles magnétiques des aimants - là où l'intensité magnétique est maximale - , soit entre deux aimants de même polarité, où l'intensité magnétique est minimale et nulle. Les trajectoires des particules chargées sont alors parallèles au champ magnétique. Dans le cas où les pôles des aimants sont situés sur les parois de l'enceinte, les particules passant dans cette zone iront par exemple percuter les parois de l'enceinte. C'est le cas notamment pour les zones situées entre deux aimants unitaires avec des polarités alternées.
   Les zones de convergences des lignes de champ magnétique sont appelées « festons ».
3/ mécanisme 3. Il s'agit d'un piégeage des particules chargées dans le champ magnétique multipolaire par mécanisme collisionnel.

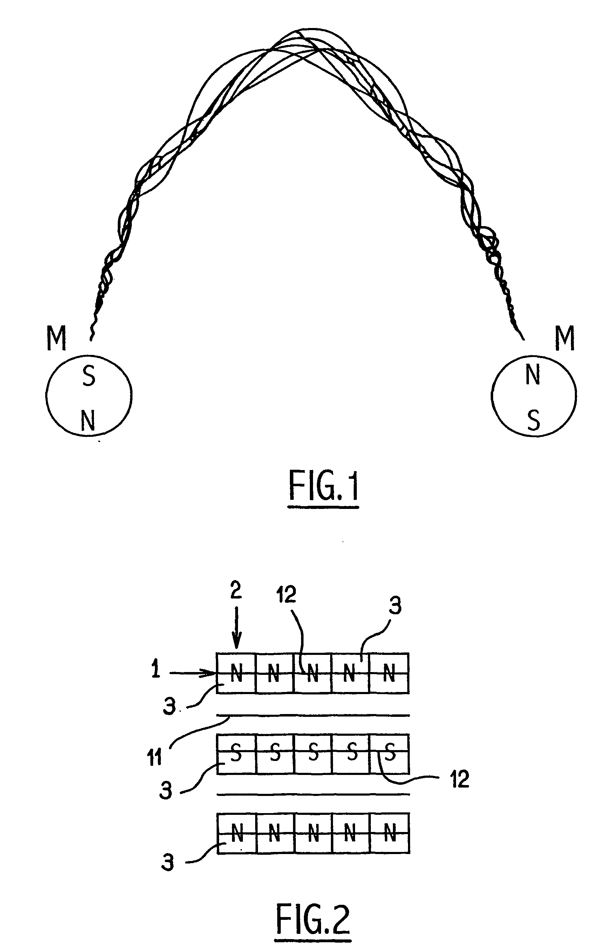

La figure 1 montre qu'une fois piégés dans le champ magnétique, et dans un intervalle entre deux collisions élastiques ou inélastiques, les électrons énergiques oscillent entre deux lignes de champ magnétique et deux points miroirs M, où l'intensité du champ magnétique est identique. Ces points miroirs M sont situés face à deux pôles magnétiques opposés du même aimant ou de deux aimants adjacents.

Les électrons énergiques qui produisent le plasma, appelés électrons rapides ou primaires, sont peu sensibles au champ électrique auto-consistant produit par la charge d'espace du plasma.

Au contraire, les ions et les électrons peu énergiques du plasma, encore appelés électrons lents ou thermiques, oscillent eux aussi entre deux pôles magnétiques opposés, mais ils sont en outre sensibles au champ électrique auto-consistant produit par la charge d'espace du plasma. Par conséquent, ils diffusent ensuite dans le champ magnétique de façon collective sous l'influence de ce champ électrique, de préférence vers les zones de champ magnétique faible ou nul.

Enfin, en dehors de ces mouvements d'oscillation et de diffusion, les particules chargées dérivent le long ou autour des aimants permanents, perpendiculairement au plan qui contient les vecteurs « champ magnétique » générés par la structure magnétique. C'est pour cette raison qu'il est préférable de fermer sur elle-même les structures de champ magnétique afin d'éviter les pertes de particules chargées aux extrémités des structures magnétiques. On obtient alors une structure de type « magnétron ».

### ETAT DE LA TECHNIQUE.

Plusieurs géométries d'alternances de polarités sont possibles pour un confinement multipolaire.

Une première géométrie classiquement utilisée est représentée à la figure 2. Une telle structure multipolaire est appelée « structure continue en ligne ». En effet, elle présente au plasma une alternance de lignes continues d'aimants permanents 3. Sur la figure 2, l'alternance de polarité se fait selon une direction que l'on référencera par 2. Les lignes continues de polarité s'étendent selon une direction référencée par 1, cette direction étant perpendiculaire à la direction d'alternance 2.

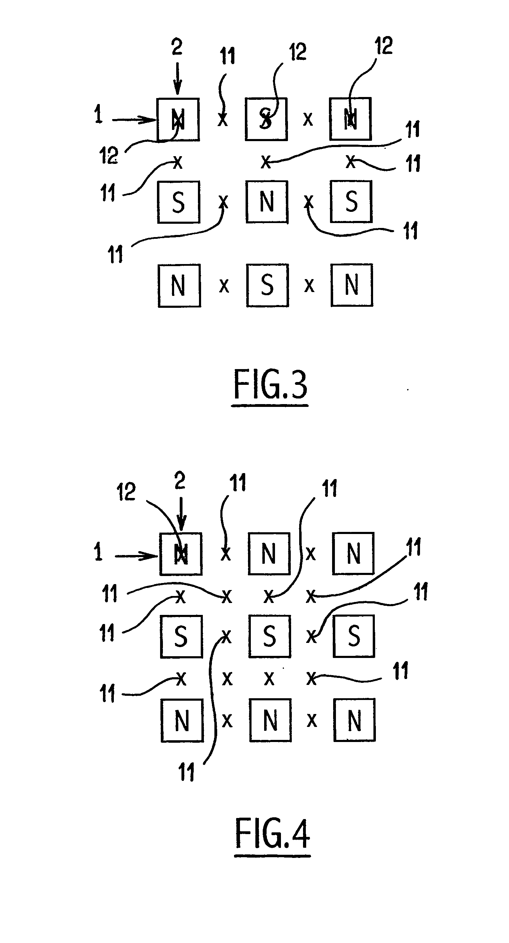

Une autre géométrie possible est représentée à la figure 3. C'est la structure « en échiquier », qui présente une alternance discontinue selon les deux directions 1 et 2. Les aimants ne sont plus disposés en lignes continues, chaque aimant a une polarité différente de ses voisins selon les directions 1 et 2.

Une troisième géométrie possible est représentée à la figure 4. Elle représente l'alternance « en ligne interrompue ». Cette structure reprend le schéma de principe de la structure de la figure 2, mais les aimants des lignes de polarités sont espacés les uns des autres.

Les publications de R. Limpaecher et K.R. MacKenzie, Rev. Sci. Instrum., vol. 44, p. 726-731 (1973), et K.N. Leung, T.K. Samec, et A. Lamm, Phys. Lett., vol. 51 A, p. 490-492 (1975), divulguent des dispositifs de confinement utilisant les structures décrites sur les figures 2 à 4.

Dans ces dispositifs, les aimants permanents sont disposés à l'intérieur ou à l'extérieur de l'enceinte de confinement, mais les aimants ont toujours un des pôles de chaque aimant situé sur une paroi de l'enceinte.

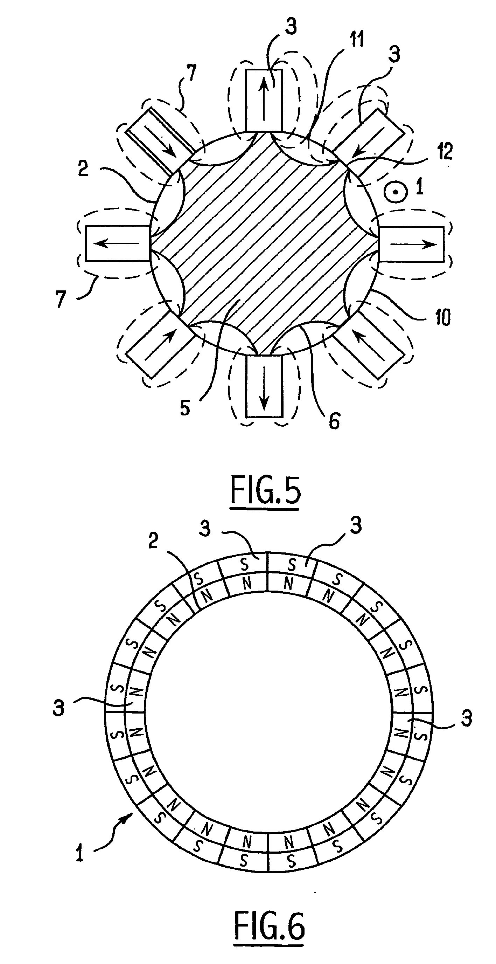

La figure 5 représente schématiquement une coupe transversale d'un exemple de dispositif divulgué dans lesdites publications. Il comporte une enceinte 10 comportant une paroi 2, un plasma 5 confiné dans l'enceinte 10 grâce à l'action d'aimants permanents 3. Dans cet exemple, les aimants sont situés à l'extérieur de l'enceinte, mais on aperçoit qu'au moins un pôle de chaque aimant 3 est sur la paroi 2. Des lignes de champ magnétique sont représentées schématiquement par les arcs de cercle 6 et 7. Les lignes d'aimantation 7 se rebouclent sur elles-mêmes et interceptent la paroi 2.

Les différentes structures d'aimants peuvent être mises en oeuvre sur le dispositif de la figure 5. On peut par exemple mettre en oeuvre les structures des figures 2 à 4 selon la direction 1 représentée sur la figure 5. La direction 1 est alors perpendiculaire au plan de la figure.

On peut également mettre en oeuvre les structures selon l'autre direction, à savoir que la direction 1 est dans le plan transversal de l'enceinte, comme représenté sur la figure 6 avec comme exemple la structure de la figure 2.

Un premier mode de réalisation selon les figures 5 ou 6 met en oeuvre une structure selon la figure 2. En faisant référence à la figure 2, on comprend qu'aucune ligne de champ magnétique 7 d'un aimant permanent ne se reboucle selon la direction 1 sur la face arrière du même aimant, puisque la structure est continue selon cette direction.

Cependant, les pertes par festons (mécanisme 2) et par piégeage (mécanisme 3) avec pertes sur les parois sont quand même très importantes dans cette structure. Elles sont en effet linéaires.

La ligne 11 représente les pertes des particules chargées qui viennent percuter le pôle d'un aimant ou la paroi située au droit dudit pôle (intensité magnétique maximale).

La ligne 12 représente les pertes des particules chargées qui viennent percuter la paroi entre deux pôles de polarité opposée (intensité magnétique minimale).

Les lignes 11 et 12 sont visibles en coupe transversale sur la figure 5.

Un deuxième mode de réalisation selon les figures 5 ou 6 met en oeuvre une structure selon la figure 3.

Les lignes de champ 7 qui se rebouclent sur un même aimant permanent 3 interceptent la paroi 2 de l'enceinte 1. On a donc encore des pertes ponctuelles à la fois par les mécanismes 2 et 3.

En effet, les points 11 de la figure 3 correspondent à la fois aux festons, et à la fois à la trajectoires des particules piégées sur les lignes de champ 7 par le mécanisme 3. Par conséquent, des particules oscillant sur une ligne de champ se rebouclant sur un même aimant 3 ou arrivant sur un feston seront interceptées par la paroi 2 de l'enceinte et sont perdues pour le plasma.

Dans les structures en échiquier, les festons et points d'impact 12 des particules piégés sur les lignes 6 sont ponctuels et correspondent aussi aux centres géométriques des faces des aimants permanents. Les pertes sont donc relativement faibles par rapport au premier mode de réalisation.

Dans la configuration d'arrangement magnétique en échiquier, seules les particules chargées réfléchies par le mécanisme 1 sont effectivement confinées par le champ magnétique créé par la série d'aimants permanents.

Un troisième mode de réalisation selon les figures 5 ou 6 met en oeuvre une structure selon la figure 4.

Il représente un cas intermédiaire des deux précédents, avec une efficacité de confinement intermédiaire aux deux autres.

En effet, il y a un rebouclement des lignes de champ sur l'arrière de l'aimant selon la direction 1. Il y a donc interception de particules chargées par la paroi de l'enceinte. Ces interceptions par le mécanisme 3 de particules par la paroi sont représentées par les croix 11.

Des pertes ponctuelles par le mécanisme 2 et 3 s'effectuent selon la direction 2.

Le document WO 01/73812 divulgue un dispositif de confinement d'un plasma selon le préambule de la revendication 1.

Outre les pertes de plasma décrites précédemment, les structures précédentes présentent des inconvénients.

Ils sont principalement au nombre de trois.
1/ Il est difficile de mettre en oeuvre et de réaliser des structures de type « magnétron » fermées sur elles-mêmes, lesdites structures permettant d'éviter les pertes de plasma aux extrémités des structures continues.
2/ Il est difficile d'introduire dans une enceinte sous vide des structures magnétiques non rectilignes. Ainsi, seules certaines géométries d'enceinte sont susceptibles de recevoir des structures d'aimants simplifiées rectilignes comme des structures cylindriques ou parallélépipédiques.
3/ Les lignes d'aimants continues nécessitent de grandes quantités d'aimants permanents coûteux et lourds.

### PRESENTATION DE L'INVENTION

L'invention propose de pallier ces inconvénients. A cet effet, l'invention propose une structure magnétique multipolaire de confinement permettant de remédier à ces inconvénients tout en conférant une efficacité de confinement très élevée aux espèces chargées du plasma.
L'invention propose donc un dispositif de confinement d'un plasma dans une enceinte comportant des moyens pour créer un champ magnétique, selon la revendication 1.

L'invention est avantageusement complétée par les caractéristiques suivantes, prises seules ou en une quelconque de leur combinaison techniquement possible :
- les tiges de support s'étendent perpendiculairement aux parois de l'enceinte ;
- la série d'aimants permanents est en structure discontinue en échiquier ;
- la série d'aimants permanents est en structure discontinue en ligne interrompue ;
- les aimants permanents ont une symétrie de révolution ;
- les aimants permanents sont de forme cylindrique ;
- les tiges ont une faible section par rapport aux dimensions des aimants permanents ;
- les tiges de support sont des tubes, les aimants permanents étant situés à l'intérieur des tubes dans l'extrémité s'étendant dans l'enceinte, chaque aimant comportant sur sa face la plus en arrière par rapport à l'intérieur de l'enceinte une plaquette ou un disque d'un matériau à haute perméabilité magnétique ;
- le matériau est du fer doux ;
- il comporte des moyens de refroidissement des aimants permanents ;
- les moyens de refroidissement comportent un circuit de circulation aller-retour d'un fluide autour de chaque aimant, ce circuit comportant une canalisation passant au centre de l'aimant ;
- les aimants permanents sont compris dans une enveloppe extérieure de protection qui comporte un matériau amagnétique conducteur ou diélectrique ;
- il comporte des moyens de production d'un plasma indépendants des moyens de confinement ;
- la source de production de plasma est une structure à excitation par filaments thermo-émissifs ;
- la source de production de plasma est une structure à excitation par application au gaz d'une tension électrique de fréquence et de forme déterminées ;
- les moyens de production du plasma comportent des moyens aptes à appliquer au gaz un champ électrique micro-onde ;
- il comporte des moyens de production d'un plasma qui utilisent au moins une partie des moyens de confinement ;
- les moyens de production de plasma sont aptes à appliquer à la structure de confinement une tension électrique de fréquence et de forme déterminées ;
- les moyens de production de plasma comportent des moyens aptes à appliquer au gaz un champ électrique micro-onde.

### PRESENTATION DES FIGURES

D'autres caractéristiques, buts et avantages de l'invention ressortiront de l'invention qui suit qui est purement illustrative et non limitative, et qui doit être lue en regard des dessins annexés sur lesquels :
- La figure 1, déjà commentée, représente la trajectoire d'une particule chargée entre deux points miroirs M situés en face d'aimants permanents ayant une polarité alternée ;
- La figure 2, déjà commentée, représente une géométrie de structure multipolaire en ligne continue ;
- La figure 3, déjà commentée, représente une structure multipolaire alternée en échiquier ;
- La figure 4 , déjà commentée, représente une structure multipolaire en ligne discontinue ou interrompue ;
- La figure 5, déjà commentée, représente une coupe transversale d'une enceinte selon l'état de la technique utilisant les structures des figures 2 à 4;
- La figure 6, déjà commentée, est une représentation en coupe transversale d'un dispositif de confinement ayant une structure multipolaire en ligne continue ;
- La figure 7 représente schématiquement une coupe transversale d'une structure générale d'un dispositif 1 de confinement selon l'invention ;
- La figure 8 est une représentation d'un détail de trois aimants permanents 3;
- La figure 9 représente schématiquement en coupe longitudinale la structure de moyens de refroidissement des aimants permanents ;
- La figure 10 est une représentation d'une vue en coupe transversale d'une variante de l'invention comportant des matériaux à haute perméabilité magnétique où les aimants permanents sont à l'intérieur de tubes de support ;
- La figure 11 représente schématiquement de face une structure en échiquier selon l'invention, sur laquelle est représentée les festons ponctuels.

### DESCRIPTION DE L'INVENTION

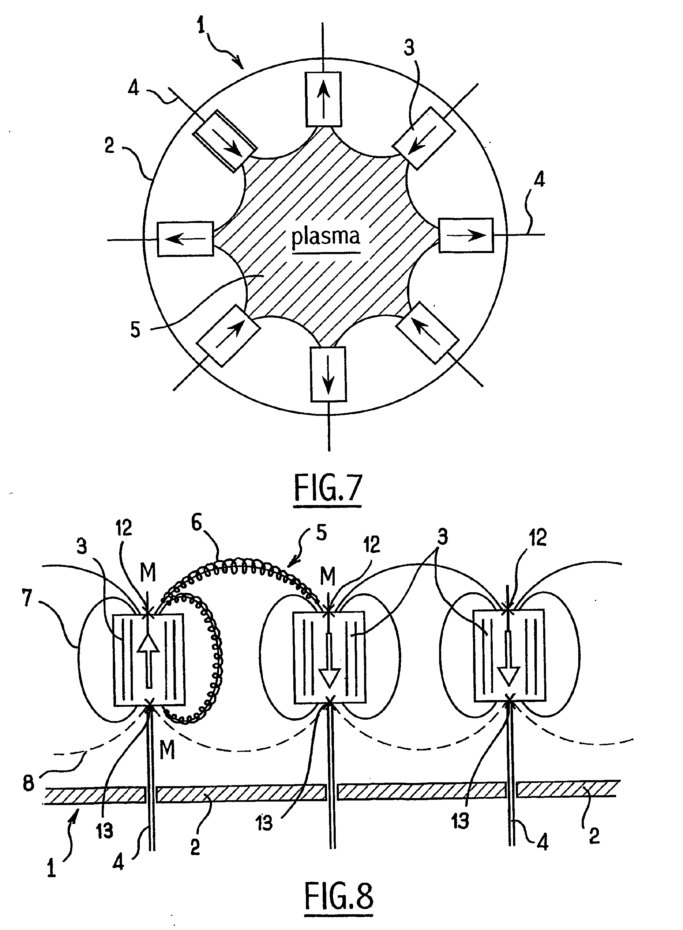

On se réfère aux figures 7 et 8 illustrant un mode de réalisation possible de l'invention.

La figure 7 représente la structure générale du dispositif de confinement selon une coupe transversale. Le dispositif comporte une enceinte 1, comportant une paroi 2 et une pluralité d'aimants permanents 3 disposés dans ladite enceinte 1. Un plasma 5 baigne l'intérieur de l'enceinte 1 et est confiné dans ladite enceinte.

La figure 8 est une représentation d'un détail de trois aimants permanents 3.

Le plasma 5 peut être produit par une source plasma quelconque (non représentée) disposée à la périphérie de ou dans l'enceinte et opérant dans le domaine de pressions inférieures à quelques 10⁻² torr.

D'une part, le plasma 5 peut être produit par des moyens indépendants des moyens de confinement.

Le plasma 5 peut par exemple être produit par excitation par filament. Dans ce cas, des électrons sont émis par des filaments thermo-émissifs intérieurs à la structure de confinement et polarisés négativement par rapport à l'enceinte et à la structure magnétique.

Pour générer le plasma à basse pression, on peut également utiliser des dispositifs permettant une application au gaz d'une tension électrique. La tension électrique peut avoir des formes et des fréquences variées en fonction des applications. La tension électrique peut par exemple être du type continue, continue pulsée, basse fréquence ou radio-fréquence.

L'excitation du plasma peut également être effectuée par l'application au gaz d'un champ électrique micro-onde. Le champ micro-onde peut être accompagné d'un champ magnétique, et par exemple être une excitation à la résonance cyclotronique électronique (RCE). Le champ micro-onde peut également ne pas être accompagné de champ magnétique, et on peut alors utiliser une excitation par onde de surface.

On peut aussi utiliser une excitation magnétron pour exciter le plasma.

D'autre part, il est également possible d'utiliser tout ou une partie des structures magnétiques de confinement pour exciter le plasma, soit par application à la structure d'une tension continue ou continue pulsée, d'une tension basse fréquence, ou radio-fréquence ; soit par application de micro-ondes, pour une excitation en champ magnétique (par exemple à la RCE) ou par onde de surface.

Ainsi, dans tous les cas, tout type d'excitation du plasma est envisageable, quel que soit la fréquence d'excitation et le mode d'excitation (RCE, décharge continue, décharge continue pulsée, décharge basse fréquence, décharge radio-fréquence, ondes de surface, décharge inductive, ou décharge magnétron ou RCE par exemple).

Le réacteur plasma décrit dans la présente demande comporte des moyens de mesure de pression et de diagnostic plasma souhaité (non représentés sur les figures).

De même l'enceinte 1 est équipée de nombreux dispositifs d'introduction de gaz et de pompage de gaz, non représentés mais connus en eux-mêmes, permettant de maintenir la pression du gaz à ioniser à une valeur souhaitée qui peut être par exemple de 10⁻⁶ torr ou moins jusqu'aux pressions de l'ordre de 10⁻² torr par exemple suivant la nature du gaz et la fréquence d'excitation.

Les aimants 3 sont fixés à l'enceinte 1 par l'intermédiaire de tiges ou de tubes de support 4 centrés sur le pôle de chaque aimant et dans le prolongement de l'axe d'aimantation de chaque aimant.

Selon un mode de réalisation possible de l'invention, les supports 4 sont de très faible diamètre par rapport aux dimensions des aimants 3, et s'étendent perpendiculairement par rapport aux parois 2 de l'enceinte 1, desdites parois 2 vers l'intérieur de l'enceinte 1.

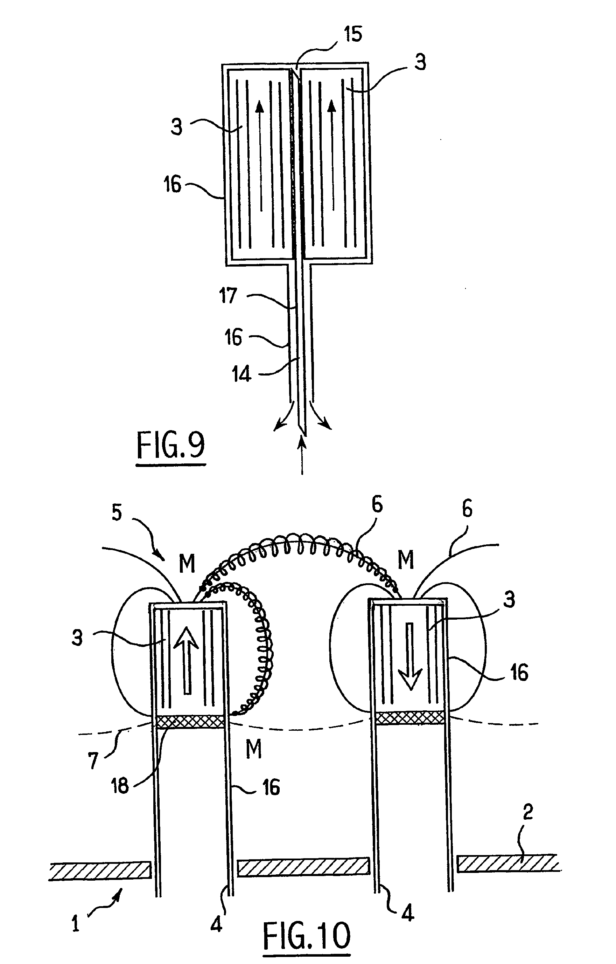

Selon un autre mode de réalisation de l'invention par exemple représenté à la figure 10, les supports 4 peuvent être sensiblement du même diamètre que les aimants. On prévoira alors des plaquettes ou des disques 18 à haute perméabilité magnétique.

De même selon un autre mode de réalisation non représenté sur les figures, les supports peuvent ne pas être perpendiculaires aux parois 2 de l'enceinte 1, mais disposés en biais par rapport aux parois.

Préférentiellement, les aimants permanents 3 possèdent des axes d'aimantation alternativement orientés d'un dispositif voisin à l'autre. On obtient alors une structure multipolaire avec une décroissance rapide, quasi exponentielle de l'intensité du champ magnétique en fonction de l'éloignement par rapport aux aimants.

Sur la figure 8, on a représenté par des traits pleins 6, 7 et pointillés 8 les lignes de champ magnétiques créées par les aimants permanents 3.

On comprend alors que le fait que les aimants permanents soient fixés à une distance des parois 2 de l'enceinte 1 telle que les parois 2 soient hors de la zone d'influence effective des aimants permet aux particules chargées issues du plasma 5, et piégées dans le champ magnétique sur les lignes 7, d'osciller librement, dans l'intervalle entre deux collisions élastiques ou inélastiques entre particules, sans obstacle entre deux points miroirs M de même intensité de champ magnétique.

De plus, les lignes de champ 8 situées entre la paroi 2 et les aimants permanents 3 ont une probabilité très faible de piéger les particules chargées issues du plasma. En effet, les particules chargées sont réfléchies par les lignes de champ 6 situées du côté du plasma 5.

On voit donc qu'il y a une probabilité très faible pour qu'une particule chargée piégée dans une ligne de champ rencontre une paroi. Les pertes de plasma par collision avec les parois de l'enceinte sont donc réduites au minimum.

La figure 8 montre que les festons 12 d'un tel dispositif sur les faces présentées au plasma 5 sont identiques aux festons ponctuels d'une structure discontinue en échiquier (figure 3) ou en ligne interrompue (figure 4). Les pertes par festons sont donc moindres que dans une structure continue (figure 2).

Selon un premier mode de réalisation possible, les supports 4 ont des sections de très petites dimensions (faible diamètre par exemple). Par conséquent, les intersections avec les lignes 7 de champ magnétique sont réduites au minimum. On obtient ainsi idéalement une dimension d'intersection 13 par les particules oscillantes sur les lignes 7 sensiblement équivalente à une dimension d'un feston ponctuel 12.

Selon une solution de réalisation représentée aux figures 7 et 8, chaque aimant est constitué par un aimant de forme cylindrique présentant une aimantation axiale qui se trouve sensiblement située dans le prolongement de l'axe du support 4.

Le fait que les aimants présentent une symétrie de révolution autour de l'axe d'aimantation permet à l'aimant de représenter à lui tout seul une structure de type « magnétron » parfaite. De cette façon, les particules piégées sur des lignes de champ de forte intensité 7, c'est-à-dire se rebouclant sur le pôle opposé du même aimant, peuvent dériver sans obstacle autour de l'axe de l'aimant.

La forme cylindrique préférentielle présente l'avantage d'être plus simple à réaliser qu'un aimant de forme sphérique mais surtout plus simple à encapsuler dans une enveloppe étanche.

L'encapsulation dans une enveloppe étanche est souvent nécessaire, d'une part pour éviter les contaminations du plasma et/ou la corrosion des aimants par le plasma, et d'autre part, pour refroidir l'aimant en cas de besoin.

Bien entendu, les matériaux d'encapsulation et de fixation des aimants sont réalisés en matériaux amagnétiques. On pourra prendre des métaux non magnétiques par exemple.

Si un refroidissement des aimants permanents est nécessaire - c'est le cas notamment pour des applications avec des plasma denses -, il peut s'effectuer par une circulation double sens de fluide par l'intermédiaire du tube de fixation 4 de chaque aimant 3.

Un exemple d'une telle encapsulation est représentée à la figure 9. Selon ce mode de réalisation préféré, chaque support 4 peut être utilisé pour permettre le montage d'une canalisation 14 d'amenée d'un fluide de refroidissement. Elle s'étend dans un alésage central pratiqué dans l'aimant 3 selon l'axe d'aimantation de l'aimant. Cette canalisation 14 réalisée sous la forme d'un tube communique, à son extrémité, avec une enceinte 15 délimitée entre l'aimant 3 et une enveloppe 16 entourant à distance l'aimant.

L'enceinte 15 débouche dans une conduite 17 de retour du fluide de refroidissement délimitée entre la canalisation d'amenée 14 et le support 4.

L'aimant 3 se trouve ainsi encapsulé par l'enveloppe de protection 16 permettant la circulation d'un fluide de refroidissement autour de l'aimant 3. Par exemple, le matériau d'encapsulation de l'aimant et celui constituant les supports 4 sont réalisés en matériau amagnétique bon conducteur (métaux non magnétiques), mais ils peuvent également être entourés, pour des raisons de contamination, par des matériaux diélectriques sans nuire au bon fonctionnement du dispositif.

Une variante illustrée à la figure 10 du dispositif selon l'invention consiste à utiliser un tube de fixation et de support 4 de diamètre constant sensiblement égal au diamètre de l'aimant permanent. Ce tube de fixation 4 permet à la fois de fixer et d'encapsuler les aimants. Chaque aimant permanent est situé dans l'extrémité du tube qui s'étend dans le plasma. On assure le refroidissement des aimants permanents si nécessaire.

Dans cette variante, on permet aux particules piégées d'osciller librement entre les points M.

Selon cette variante, chaque aimant permanent 3 présent dans un tube 4 présente sur sa face polaire la plus éloignée du plasma un matériau à haute perméabilité magnétique 18 - telle que par exemple une plaquette ou un disque de fer doux. Dans cette configuration, les électrons peuvent aussi osciller entre deux points miroir M. L'un des points M n'est plus situé en face du pôle de l'aimant, mais sur le côté, le long du support 4, tandis que l'autre point M reste en face du pôle. Ainsi, la présence de la plaquette ou du disque 18 disposée sur la face la plus externe par rapport au plasma 5, permet de modifier la position spatiale des points miroir M associés aux pôles de chaque aimant permanent 3.

De telles structures magnétiques présentent une grande efficacité de confinement du plasma, et peuvent être adaptées à des géométries d'enceinte très variées par exemple cylindriques comme représenté à la figure 7.

### AVANTAGES

Les dispositifs décrits permettent d'obtenir une très grande efficacité de confinement du plasma.

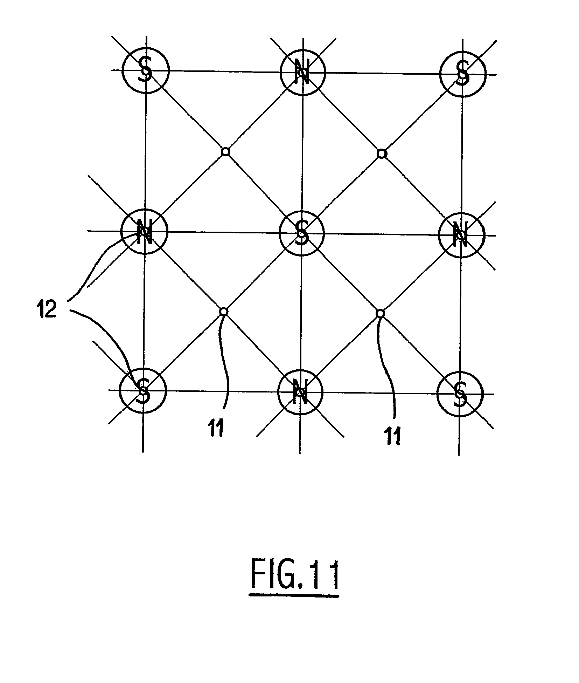

En effet, ils minimisent les pertes en particules chargées par les différents mécanismes. En particulier, comme le représente la figure 11, les pertes sur les festons sont réduites. Dans la structure en échiquier utilisée dans les modes de réalisation possibles de l'invention, les lignes de champ 6 forment une barrière protectrice sur laquelle les particules viennent se réfléchir ou osciller. Sur la figure 11, les points 11 et 12 montrent les festons ponctuels. Ainsi, dans une telle structure, il n'y a en moyenne que deux festons ponctuels par aimant permanent, contrairement à toute une ligne de festons sur une structure continue.

En outre, chaque aimant permanent constitue une structure magnétron tridimensionnelle parfaite, de par sa symétrie de révolution, ce qui limite d'autant les pertes en particules chargées et assure de surcroît une stabilité parfaite au plasma.

Au surplus, les structures multidipolaires proposées par l'invention sont très faciles à mettre en oeuvre. Elles ne nécessitent qu'un nombre très réduit d'aimants permanents par rapport à une structure continue en ligne, ce qui pour des enceintes de grand volume procure des gains importants de coût et de poids.

Les structures magnétiques multidipolaires proposées par l'invention utilisent des aimants de même nature (en ferrite de baryum strontium, en samarium-cobalt, en néodyme-fer-bore par exemple) et de même dimension (aimants unitaires de l'ordre du centimètre, distance entre aimants de quelques centimètres) que dans les structures multipolaires conventionnelles.

A titre d'exemples non limitatifs, une telle structuré multidipolaire de confinement peut être réalisée avec des aimants samarium-cobalt avec un diamètre de 2 cm, et une longueur de 3 cm, disposés tous les 7 cm à la périphérie d'une enceinte cylindrique.

Le dispositif selon l'invention est avantageusement utilisé dans l'implantation ionique par immersion plasma (PBII ou Plasma Based Ion Implantation), la pulvérisation directe ou réactive assistée par plasma, la CVD (Chemical Vapor Depostion) assistée par plasma micro-onde, la gravure, voire les traitements thermo-chimiques.

On peut également citer leur application à la pulvérisation des matériaux magnétiques, les dépôts de diélectriques à forte permittivité, comme par exemple les oxydes de grille en micro électronique.

## Revendications

1. Dispositif de confinement d'un plasma (5) dans une enceinte (1) d'un grand volume, comportant des moyens pour créer un champ magnétique, lesdits moyens comportant une série d'aimants permanents (3) disposés à l'intérieur de l'enceinte, de façon éloignée des parois de l'enceinte aptes à créer un champ magnétique présentant au plasma une structure magnétique multipolaire alternée, les aimants étant répartis de façon discontinue autour du volume, **caractérisé en ce que** les aimants sont éloignés des parois (2) par des tiges (4) de support, les tiges (4) de support s'étendant selon l'axe d'aimantation desdits aimants et étant disposées de façon centrée sur les pôles des aimants permanents, de sorte que les parois (2) soient hors de la zore d'influence effective des aimants (3).

2. Dispositif selon la revendication 1, **caractérisé en ce que** les tiges de support (4) s'étendent perpendiculairement aux parois de l'enceinte.

3. Dispositif selon l'une des revendications 1 ou 2, **caractérisé en ce que** la série d'aimants permanents (3) est en structure discontinue en échiquier.

4. Dispositif selon l'une des revendications 1 à 3, **caractérisé en ce que** la série d'aimants permanents (3) est en structure discontinue en ligne interrompue.

5. Dispositif selon l'une des revendications 1 à 4, **caractérisé en ce que** les aimants permanents (3) ont une symétrie de révolution.

6. Dispositif selon l'une des revendications 1 à 5, **caractérisé en ce que** les aimants permanents sont de forme cylindrique.

7. Dispositif selon l'une des revendications 1 à 6, **caractérisé en ce que** les tiges ont une faible section par rapport aux dimensions des aimants permanents.

8. Dispositif selon l'une des revendications 1 à 6, **caractérisé en ce que** les tiges (4) de support sont des tubes, les aimants permanents étant situés à l'intérieur des tubes (4) dans l'extrémité s'étendant dans l'enceinte (1), chaque aimant comportant sur sa face la plus en arrière par rapport à l'intérieur de l'enceinte (1) une plaquette ou un disque (18) d'un matériau à haute perméabilité magnétique.

9. Dispositif selon la revendication 8, **caractérisé en ce que** le matériau est du fer doux.

10. Dispositif selon l'une des revendications 1 à 9, **caractérisé en ce qu'**il comporte des moyens de refroidissement des aimants permanents (3).

11. Dispositif selon la revendication 10, **caractérisé en ce que** les moyens de refroidissement comportent un circuit de circulation aller-retour d'un fluide autour de chaque aimant, ce circuit comportant une canalisation passant au centre de l'aimant.

12. Dispositif selon l'une des revendication 1 à 11, **caractérisé en ce que** les aimants permanents sont compris dans une enveloppe extérieure de protection (16) qui comporte un matériau amagnétique conducteur ou diélectrique.

13. Dispositif selon l'une des revendications 1 à 12, **caractérisé en ce qu'**il comporte des moyens de production d'un plasma indépendants des moyens de confinement.

14. Dispositif selon la revendication 13, **caractérisé en ce que** la source de production de plasma est une structure à excitation par filaments thermo-émissifs.

15. Dispositif selon la revendication 13, **caractérisé en ce que** la source de production de plasma est une structure à excitation par application au gaz d'une tension électrique de fréquence et de forme déterminées pour une application souhaitée.

16. Dispositif selon la revendication 13, **caractérisé en ce que** les moyens de production du plasma comportent des moyens aptes à appliquer au gaz un champ électrique micro-onde.

17. Dispositif selon l'une des revendications 1 à 12, **caractérisé en ce qu'**il comporte des moyens de production d'un plasma qui utilisent au moins une partie des moyens de confinement.

18. Dispositif selon la revendication 17, **caractérisé en ce que** les moyens de production de plasma sont aptes à appliquer à la structure de confinement une tension électrique de fréquence et de forme déterminées pour une application souhaitée.

19. Dispositif selon la revendication 17, **caractérisé en ce que** les moyens de production comportent des moyens aptes à appliquer au gaz un champ électrique micro-onde.

## Claims

1. Device for confinement of plasma (5) in a large volume chamber (1) comprising means for creating a magnetic field, the said means comprising a series of permanent magnets (3) arranged inside the chamber, at a distance from the walls of the chamber, capable of creating a magnetic field presenting an alternating multipole magnetic structure, to the plasma, the magnets being discontinuously distributed around the volume, **characterised in that** the magnets are at a distance from the walls (2) by support rods (4), the support rods (4) extending along the axis of magnetisation of the said magnets and being arranged so that they are centred on the poles of the permanent magnets, such that the walls (2) are outside the effective area of influence of the magnets (3).

2. Device according to claim 1, **characterised in that** the support rods (4) extend perpendicular to the walls of the chamber.

3. Device according to either claim 1 or 2, **characterised in that** the series of permanent magnets (3) is in a discontinuous checkerboard type structure.

4. Device according to one of claims 1 to 3, **characterised in that** the series of permanent magnets (3) is in a discontinuous structure with an interrupted line.

5. Device according to one of claims 1 to 4, **characterised in that** the permanent magnets (3) have a symmetry of revolution.

6. Device according to one of claims 1 to 5, **characterised in that** the permanent magnets are cylindrical.

7. Device according to one of claims 1 to 6, **characterised in that** the cross-section of the rods is small compared with the dimensions of the permanent magnets.

8. Device according to one of claims 1 to 6, **characterised in that** the support rods (4) are tubes, the permanent magnets being located inside the tubes (4) in the end extending into the chamber (1), each magnet comprising a plate or a disk (18) made of a material with high magnet permeability on its face furthest back from the inside of the chamber (1).

9. Device according to claim 8, **characterised in that** the material is soft iron.

10. Device as claimed in one of claims 1 to 9, **characterised in that** it comprises means of cooling the permanent magnets (3).

11. Device according to claim 10, **characterised in that** the cooling means comprise a supply-return circulation circuit for a fluid around each magnet, this circuit comprising a pipe passing through the centre of the magnet.

12. Device according to one of claims 1 to 11 **characterised in that** the permanent magnets are contained in an external protective enclosure (16) that contains a non-magnetic conducting or dielectric material.

13. Device according to one of claims 1 to 12, **characterised in that** it comprises means of producing plasma that are independent of the confinement means.

14. Device according to claim 13, **characterised in that** the plasma production source is a structure with thermo-emissive filament excitation.

15. Device according to claim 13, **characterised in that** the plasma production source is a structure excited by application of an electric voltage with a given frequency and shape, to the gas, for a required application.

16. Device according to claim 13, **characterised in that** plasma production means contain means capable of applying a microwave electric field to the gas.

17. Device according to one of claims 1 to 12, **characterised in that** it comprises plasma production means that use at least a part of the confinement means.

18. Device according to claim 17, **characterised in that** the plasma production means are capable of applying an electric voltage with a determined frequency and shape to the confinement structure, for a required application.

19. Device according to claim 17, **characterised in that** the production means include means capable of applying an electric microwave field to the gas.

## Patentansprüche

1. Vorrichtung zum Einschluß eines Plasmas (5) in einer großvolumigen Kammer (1), die Mittel zum Erzeugen eines magnetischen Feldes umfaßt, wobei die Mittel eine Reihe von Permanentmagneten (3) umfassen, die innerhalb der Kammer in einem Abstand von den Kammerwänden angeordnet sind und die dafür eingerichtet sind, ein magnetisches Feld zu erzeugen, das für das Plasma eine abwechselnde multipolare magnetische Struktur bereitstellt, wobei die Magnete auf diskontinuierliche Weise um das Volumen herum verteilt sind, **dadurch gekennzeichnet, daß** die Magnete von den Wänden (2) durch Trägerstangen (4) auf Abstand gehalten werden, wobei die Trägerstangen (4) sich entlang der Magnetisierungsachse der Magnete erstrecken und auf die Pole der Permanentmagnete zentriert angeordnet sind, derart, daß die Wände (2) außerhalb der wirksamen Einflußzone der Magnete (3) liegen.

2. Vorrichtung nach Anspruch 1, **dadurch gekennzeichnet, daß** die Trägerstangen (4) sich senkrecht zu den Wänden der Kammer erstrecken.

3. Vorrichtung nach einem der Ansprüche 1 oder 2, **dadurch gekennzeichnet, daß** die Reihe von Permanentmagneten (3) in einer diskontinuierlichen Schachbrettstruktur vorliegen.

4. Vorrichtung nach einem der Ansprüche 1 bis 3, **dadurch gekennzeichnet, daß** die Reihe von Permanentmagneten (3) in einer diskontinuierlichen Struktur einer unterbrochenen Linie vorliegen.

5. Vorrichtung nach einem der Ansprüche 1 bis 4, **dadurch gekennzeichnet, daß** die Permanentmagnete (3) eine Rotationssymmetrie haben.

6. Vorrichtung nach einem der Ansprüche 1 bis 5, **dadurch gekennzeichnet, daß** die Permanentmagnete eine zylindrische Form haben.

7. Vorrichtung nach einem der Ansprüche 1 bis 6, **dadurch gekennzeichnet, daß** die Stangen im Verhältnis zu den Abmessungen der Permanentmagnete einen kleinen Querschnitt haben.

8. Vorrichtung nach einem der Ansprüche 1 bis 6, **dadurch gekennzeichnet, daß** die Trägerstangen (4) Röhren sind, wobei die Permanentmagnete sich im Inneren der Röhren (4) befinden, an dem Ende, das sich in die Kammer (1) erstreckt, wobei jeder Magnet auf seiner in Bezug auf das Innere der Kammer (1) am weitesten hinten liegenden Seite eine Platte oder Scheibe (18) aus einem Material hoher magnetischer Permeabilität umfaßt.

9. Vorrichtung nach Anspruch 8, **dadurch gekennzeichnet, daß** das Material Weicheisen ist.

10. Vorrichtung nach einem der Ansprüche 1 bis 9, **dadurch gekennzeichnet, daß** sie Kühlungsmittel für die Permanentmagnete (3) umfaßt.

11. Vorrichtung nach Anspruch 10, **dadurch gekennzeichnet, daß** die Kühlungsmittel einen Kreislauf für eine hin- und rücklaufende Zirkulation eines Fluids um jeden Magneten umfassen, wobei dieser Kreislauf eine Leitung umfaßt, die durch das Zentrum des Magneten läuft.

12. Vorrichtung nach einem der Ansprüche 1 bis 11, **dadurch gekennzeichnet, daß** die Permanentmagnete in einer äußeren Schutzhülle (16) enthalten sind, die ein leitendes oder dielektrisches unmagnetisches Material umfaßt.

13. Vorrichtung nach einem der Ansprüche 1 bis 12, **dadurch gekennzeichnet, daß** sie Mittel zur Erzeugung eines Plasma umfaßt, die unabhängig von den Einschlußmitteln sind.

14. Vorrichtung nach Anspruch 13, **dadurch gekennzeichnet, daß** die Plasmaerzeugungsquelle ein Aufbau mit einer Erregung durch Thermoemissionsfäden ist.

15. Vorrichtung nach Anspruch 13, **dadurch gekennzeichnet, daß** die Plasmaerzeugungsquelle ein Aufbau mit einer Erregung durch die Anwendung einer elektrischen Spannung auf ein Gas ist, deren Frequenz und Form für eine gewünschte Anwendung festgelegt sind.

16. Vorrichtung nach Anspruch 13, **dadurch gekennzeichnet, daß** die Plasmaerzeugungsmittel Mittel umfassen, die dafür eingerichtet sind, auf ein Gas ein elektrisches Mikrowellenfeld anzuwenden.

17. Vorrichtung nach einem der Ansprüche 1 bis 12, **dadurch gekennzeichnet, daß** sie Mittel zur Erzeugung eines Plasmas umfaßt, die wenigstens einen Teil der Einschlußmittel verwenden.

18. Vorrichtung nach Anspruch 17, **dadurch gekennzeichnet, daß** die Plasmaerzeugungsmittel dafür eingerichtet sind, auf die Einschlußstruktur eine elektrische Spannung anzuwenden, deren Frequenz und Form für eine gewünschte Anwendung festgelegt sind.

19. Vorrichtung nach Anspruch 17, **dadurch gekennzeichnet, daß** die Erzeugungsmittel Mittel umfassen, die dafür eingerichtet sind, auf ein Gas ein elektrisches Mikrowellenfeld anzuwenden.
